(19)

Europäisches Patentamt
European Patent Office
Office européen des brevets

(11) **EP 2 366 658 A2**

(12) **EUROPEAN PATENT APPLICATION**

(43) Date of publication:
**21.09.2011 Bulletin 2011/38**

(51) Int Cl.:
**B81B 7/00** (2006.01)

(21) Application number: **10195404.8**

(22) Date of filing: **16.12.2010**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **15.03.2010 JP 2010058462**

(71) Applicant: **Omron Co., Ltd.**
**Kyoto-shi, Kyoto 600-8530 (JP)**

(72) Inventors:
• **Miyaji, Takaaki**
  **Kyoto-shi, Kyoto 600-8530 (JP)**
• **Sano, Akihiko**
  **Kyoto-shi, Kyoto 600-8530 (JP)**

• **Inoue, Tadashi**
  **Kyoto-shi, Kyoto 600-8530 (JP)**
• **Okuno, Toshiaki**
  **Kyoto-shi, Kyoto 600-8530 (JP)**
• **Hada, Yoshiki**
  **Kyoto-shi, Kyoto 600-8530 (JP)**
• **Doi, Sayaka**
  **Kyoto-shi, Kyoto 600-8530 (JP)**
• **Ashihara, Yoshiki**
  **Kyoto-shi, Kyoto 600-8530 (JP)**

(74) Representative: **Wilhelms · Kilian & Partner**
**Patentanwälte**
**Eduard-Schmid-Straße 2**
**81541 München (DE)**

(54) **Electrode structure for a microdevice package**

(57)    An aspect of the invention provides a high-joining-strength electrode structure, in which a Cu electrode can be thinned and a crack, a void, and peel-off are hardly generated even if the Cu electrode is thinned. A Cu through-interconnection (75) is provided in a through-hole (72) made in a cover substrate (71). In a surface of the cover substrate (71), a Cu electrode (82) is provided in an end portion of the through-interconnection (75). A whole surface of the Cu electrode (82) is covered with a diffusion preventing film (83) that is made of a material such as Ti and Ni in which a diffusion coefficient of Sn is equal to or lower than $3 \times 10^{-23}$ cm$^2$/sec. A wettability improving layer (84) made of Au is provided on the diffusion preventing film (83), and a solder layer (85) made of Au-Sn solder is provided on the wettability improving layer (84).

## FIG. 4A

**(Cont. next page)**

EP 2 366 658 A2

*FIG. 4B*

D1

85

D2

84

D3

83

D5

82

D4

74

71    73    75    72

## Description

## BACKGROUND OF THE INTENTION

### 1. TECHNICAL FIELD

The present invention relates to an electrode structure and a microdevice package provided therewith.

### 2. RELATED ART

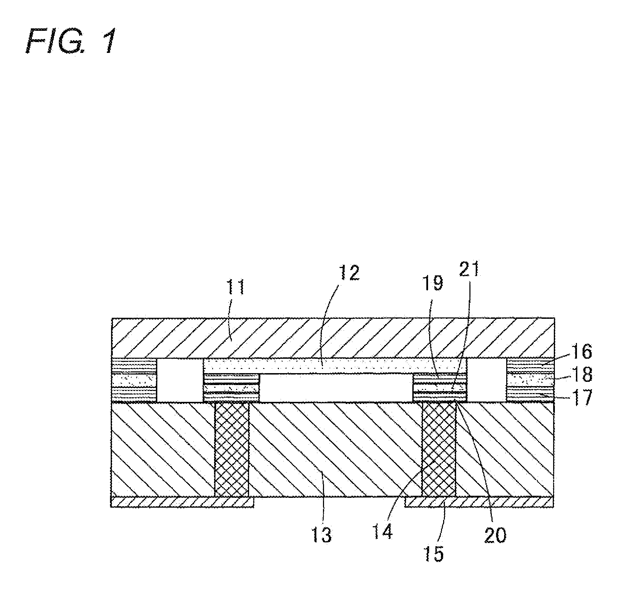

Japanese Unexamined Patent Publication No. 6-318625 discloses a package in which an electronic device is hermetic-sealed, As shown in Fig. 1, the package includes a device substrate 11 and a cover substrate 13. An electronic device 12 such as a SAW device is mounted on a lower surface of the device substrate 11, and a separator/barrier layer 16 is formed in a periphery of the lower surface of the device substrate 11. A through-interconnection (conduction path) 14 pierces the cover substrate 13 from an upper surface toward a lower surface, and an external electric terminal 15 is provided in the lower surface of the cover substrate 13 while having electric continuity to the through-interconnection 14. A separator/barrier layer 17 is formed in the periphery of the upper surface of the cover substrate 13.

In the device substrate 11 and the cover substrate 13, the separator/barrier layer 16 and the separator/barrier layer 17 are joined by solder 18 to hermetic-seal the electronic device 12. A solder terminal 19 having electric continuity to the electronic device 12 and an electrode 20 provided in an end face of the through-interconnection 14 are joined by solder 21.

Japanese Unexamined Patent Publication No. 2007-149742 also discloses a package that seals the microdevice. In the package of Japanese Unexamined Patent Publication No. 2007-149742, a through-electrode that penetrates a substrate of the package is connected to an internal element.

Occasionally Cu having high thermal conductivity is used as the through-interconnection of the package or the electrode in the end face of the through-interconnection. In order to decrease a thickness of the package, it is necessary to thin the electrode in the end face of the through-interconnection as much as possible.

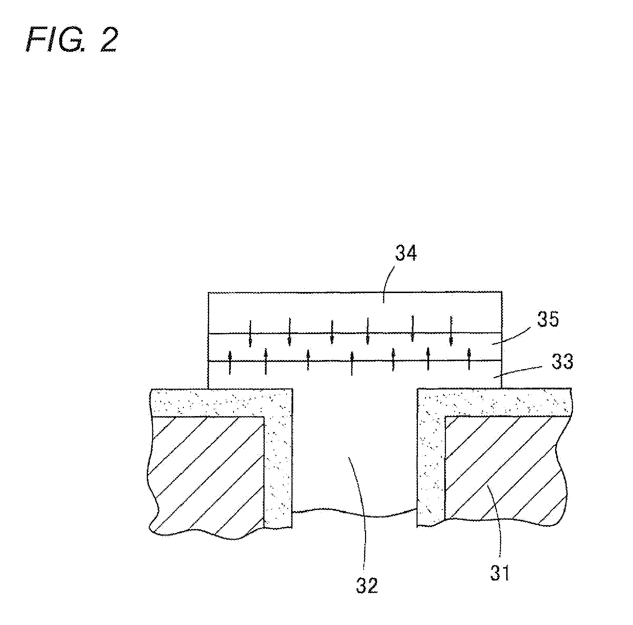

However, as shown in Fig. 2, when a solder layer 34 is stacked on a Cu electrode 33 provided in an end face of a through-interconnection 32 of a substrate 31, mutual diffusion of Cu and the solder is generated in an interfacial region 35 between the Cu electrode 33 and the solder layer 34. Therefore, when the Cu electrode 33 is thin, a crack, a void, and peel-off are easily generated in the interfacial region 35 between the Cu electrode 33 and the solder layer 34.

Accordingly, the Cu electrode or electrode portion cannot be thinned when the soldering is performed to the Cu electrode, which causes a problem in that the low-profile package is hardly obtained.

## SUMMARY

The present invention has been devised to solve the problems described above, and an object thereof is to provide an electrode structure, in which the Cu electrode can be thinned, the crack, the void, and the peel-off are hardly generated even if the Cu electrode is thinned, and excellent airtightness and resistance to degradation to a change in environment due to heat are achieved because of high joining strength. Another object of the present invention is to provide a package having an electrode structure that can be produced through a general MEMS production process.

In accordance with a first aspect of the present invention, an electrode structure includes: a Cu electrode that provided in a surface of a substrate; a diffusion preventing film that is made of a material in which a diffusion coefficient af Sn is equal to or lower than $3 \times 10^{-23}$ cm$^2$/sec, the whole Cu electrode being covered with the diffusion preventing film; and a solder layer being made of Au-Sn solder. The electrode structure is effectively applied to the through-interconnection structure in which the Cu electrode constitutes a plug portion that is provided in the end portion of the through-interconnection buried in the through-hole of the substrate.

In the electrode structure according to the first aspect of the present invention, the Cu electrode is covered with the diffusion preventing film, and the diffusion preventing film is made of the material in which the diffusion coefficient of Sn is equal to or lower than $3 \times 10^{-23}$ cm$^2$/sec. Therefore, mutual diffusion between Cu of the Cu electrode and Sn of the solder layer can be suppressed to prevent the generation of the crack in the electrode portion.

The crack or the like is hardly generated even if the Cu electrode is thinned. Particularly, the crack or the like is hardly generated in the electrode portion even if the thickness of the Cu electrode is decreased to 2 $\mu$m or less.

Particularly Ti or Ni is suitably used as the material in which the diffusion coefficient of Sn is equal to or lower than $3 \times 10^{-23}$ cm$^2$/sec.

In another embodiment of the present invention, a wettability improving layer is formed between the diffusion preventing film and the solder layer in order to improve wettability of the Au-Sn solder. Accordingly, the wettability of the solder layer is stabilized when the solder layer is melted. Particularly, when the whole surface of the diffusion preventing film is covered with the wettability improving layer, the wettability of the solder layer provided on the wettability improving layer is extremely stabilized.

In still another embodiment of the present invention, an area of the solder layer is equal to or smaller than an area of the Cu electrode. Accordingly, because the solder layer is located on the Cu electrode having the high thermal conductivity, the solder layer is easily deformed in joining the solder layer.

When the diffusion preventing film includes a flange portion that spreads out of the Cu electrode, because the Cu electrode is not located below the flange portion, the heat is hardly transferred to the flange portion, and the solder layer flowing to the flange portion is cooled and easily solidified to hardly flow to the outside. Because the flange portion is formed lower than the Cu electrode, the solder layer further hardly spreads.

In still another embodiment of the present invention, preferably a thickness of the diffusion preventing film is equal to or smaller than 1 $\mu$m, and preferably a thickness of the solder layer is equal to or lower than 5 $\mu$m.

In still another embodiment of the present invention, preferably the substrate is a semiconductor substrate whose surface is covered with an insulating film, and an adhesion layer is formed between the Cu electrode and the insulating film so as not to spread out of the diffusion preventing film, the adhesion layer having an area larger than that of the Cu electrode. Accordingly, the adhesiveness between the copper electrode and the insulating film can be enhanced by the adhesion layer. Additionally, because the solder layer does not come into contact with the adhesion layer, the mutual diffusion is not generated between the solder layer and the adhesion layer. Preferably the adhesion layer has a diffusion barrier capability against the through-electrode into the insulating layer.

In the electrode structure according to the first aspect of the present invention, preferably the adhesion layer is one or a plurality of layers made of at least one kind of materials consisting of Ti, TiN, TaN, and Ta.

In accordance with a second aspect of the present invention, a microdevice package includes: a first substrate on which a microdevice is mounted; and a second substrate that is joined to the first substrate to seal the microdevice, wherein a connecting electrode portion connected to the microdevice is formed by: a Cu electrode that is provided in an inner surface of the second substrate in an end portion of a through-interconnection buried in a through-hole of the second substrate; a diffusion preventing film that is made of a material in which a diffusion coefficient of Sn is equal to or lower than $3 \times 10^{-23}$ cm$^2$/sec, the whole Cu electrode being covered with the diffusion preventing film; and a solder layer that is made of Au-Sn solder.

In the microdevice package according to the second aspect of the present invention, the electrode structure according to the first aspect of the present invention is used in the through-interconnection portion, and the mutual diffusion between the Cu electrode and Sn of the solder layer can be suppressed in the through-interconnection portion to prevent the generation of the crack or the like in the electrode portion. Particularly the crack is hardly generated even if the Cu electrode is thinned.

In accordance with a third aspect of the present invention, a microdevice package includes: a first substrate on which a microdevice is mounted; and a second substrate that is disposed opposite the first substrate, wherein a sealing pad portion connected to the first substrate is formed by: a Cu electrode that is provided along an outer peripheral portion in an inner surface of the second substrate; a diffusion preventing film that is made of a material in which a diffusion coefficient of Sn is equal to or lower than $3 \times 10^{-23}$ cm$^2$/sec, the whole Cu electrode being covered with the diffusion preventing film; and a solder layer that is made of Au-Sn solder.

In the microdevice package according to the third aspect of the present invention, the electrode structure according to the first aspect of the present invention is used in the sealing and joining portion, and the mutual diffusion between the Cu electrode and Sn of the solder layer can be suppressed in the sealing and joining portion to prevent the generation of the crack or the like in the electrode portion. Particularly the crack or the like is hardly generated even if the Cu electrode is thinned.

In the microdevice package according to the second or third aspect of the present invention, preferably a thickness of the solder layer is equal to or lower than 3 $\mu$m after joining. When the thickness of the solder layer is set to 3 $\mu$m or less, the thickness of the package can be decreased, and the solder layer can easily be formed through a general MEMS production process.

The means for solving the problem in the invention has the feature that the above-described constituents are appropriately combined, and many variations can be made by combining the constituents in the present invention.

BRIEF DESCRIPTION OF THE DRAWINGS

Fig. 1 is a sectional view of a package disclosed in Japanese Unexamined Patent Publication No. 6-318625;

Fig. 2 is a schematic sectional view of an electrode portion in which a solder layer is stacked on a surface of a Cu electrode;

Fig. 3 is a sectional view of a package according to an embodiment of the present invention;

Fig. 4A is an enlarged view showing an X portion of Fig. 3, that is, a connecting electrode structure while the X portion is vertically inverted, and Fig. 4B is an enlarged view showing some layers of the X portion while the layers are separated from one another;

Fig. 5A is an enlarged view showing a Y portion of Fig. 3, that is, a sealing pad structure while the Y portion is vertically inverted, and Fig. 5B is an enlarged view showing some layers of the Y portion while the layers are separated from one another;

Fig. 6 is a perspective view showing schematically a state in which the connecting electrode structure and the sealing pad structure are joined;

Fig. 7A is a sectional view of a cover substrate, Fig.

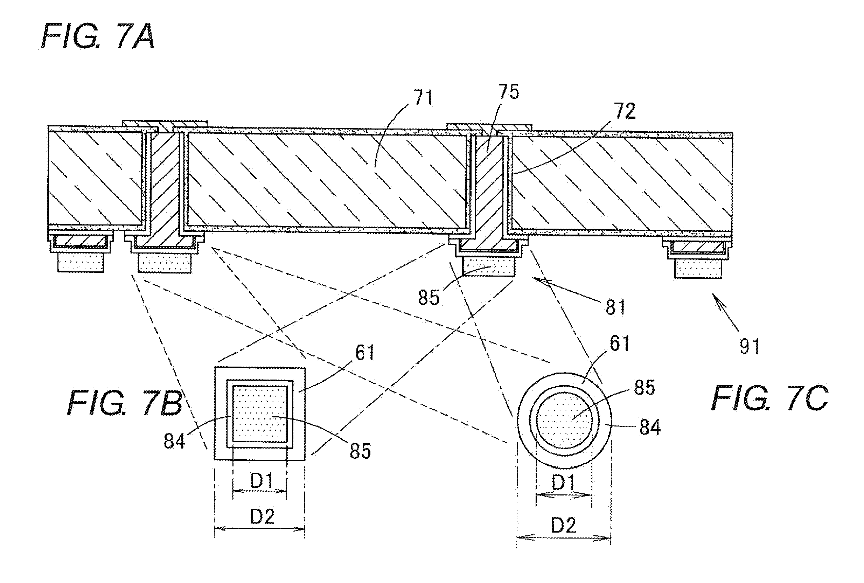

7B shows a lower surface shape of the connecting electrode structure, and Fig. 7C shows another lower surface shape of the cover substrate;

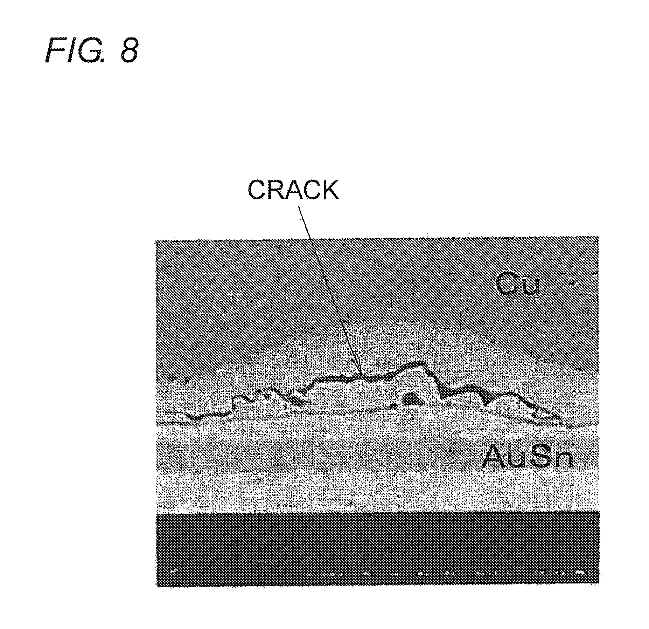

Fig. 8 shows a state in which Sn diffuses in Cu; and

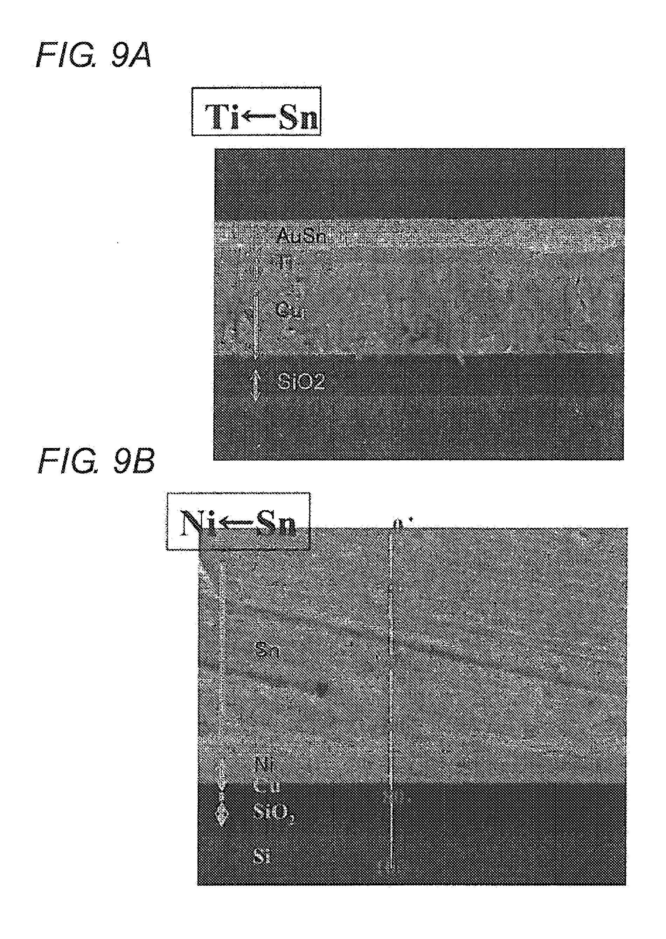

Fig. 9A shows a state in which Sn diffuses in Ti, and Fig. 9B shows a state in which Sn diffuses in Ni.

DETAILED DESCRIPTION

Hereinafter, a preferred embodiment of the present invention will be described with reference to the drawings. However, the present invention is not limited to the following embodiment, but various design changes can be made without departing from the scope of the present invention.

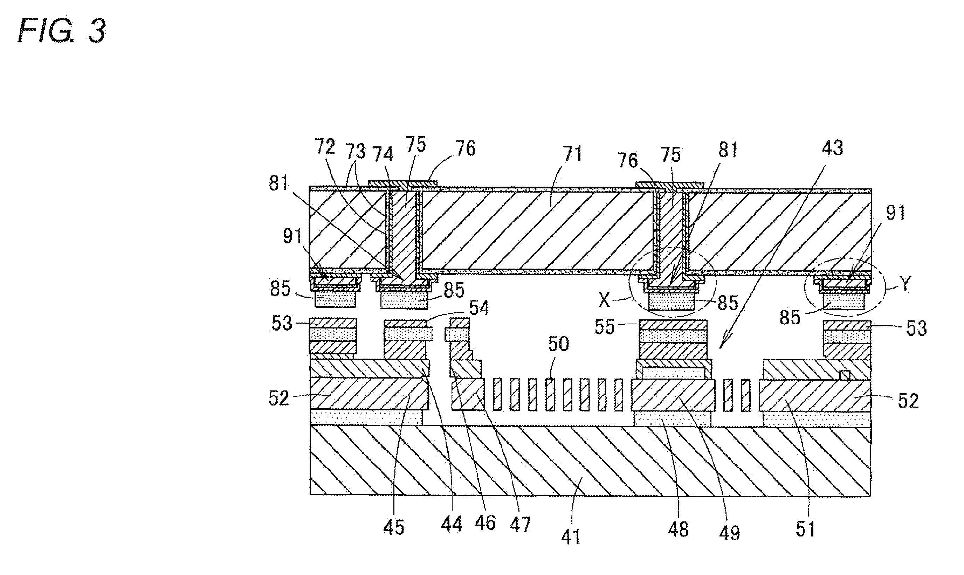

Fig. 3 is a sectional view showing a structure of a package according to an embodiment of the present invention in which an electrostatic relay is sealed. The package includes a device substrate 41 and a cover substrate 71. An electrostatic relay 43 is formed in an upper surface of the device substrate 41, and the electrostatic relay 43 includes a high-frequency switch unit and an electrostatic actuator that drives the switch unit. The switch unit includes a fixed contact portion 45 and a moving contact portion 47. The fixed contact portion 45 includes a pair of fixed contacts 44, and the moving contact portion 47 includes a moving contact 46 that opens and closes between fixed contacts 44. The electrostatic actuator includes an actuator fixed portion 49, an actuator moving portion 50, and a retention portion 51. The actuator fixed portion 49 is fixed to the upper surface of the device substrate 41 with an insulating layer 48 interposed therebetween. The actuator moving portion 50 is displaced by an electrostatic force to move the moving contact portion 47. In the retention portion 51, the actuator moving portion 50 is retained by an elastic spring while being able to be displaced. A frame-shaped sealing portion 52 is formed around the upper surface of the device substrate 41 so as to surround the electrostatic relay 43 (the switch unit and the electrostatic actuator are formed using a common Si substrate, and an outer peripheral portion of the Si substrate or the like constitutes the sealing portion 52).

A joining pad 53 is formed into the frame shape in an uppermost surface of the sealing portion 52. A pair of fixed contact pads 54 is formed above the fixed contact portion 45 while having electric continuity to each fixed contact 44. An actuator pad 55 is provided above the actuator fixed portion 49 while having electric continuity to the actuator fixed portion 49. Similarly an actuator pad (not shown) is provided above the actuator moving portion 50 while having electric continuity to the actuator moving portion 50. The upper surfaces of the joining pad 53, fixed contact pad 54, and actuator pad 55 are flush with one another.

The cover substrate 71 formed by an Si substrate includes plural through-holes 72, and a lower surface of the cover substrate 71 and an inner surface of the through-hole 72 are covered with insulating layers 73 made of $SiO_2$. A through-interconnection 75 made of Cu is buried in the through-hole 72 while the insulating layer 73 and an adhesion layer 74 are interposed therebetween. An upper surface of the cover substrate 71 and an upper surface of the through-interconnection 75 are covered with the insulating layer 73. An external connection terminal 76 is provided in the upper surface of the cover substrate 71, and the external connection terminal 76 is connected to the through-interconnection 75 through a contact hole made in the insulating layer 73. In the lower surface of the cover substrate 71, connecting electrode structures 81 are provided in lower end portions of the through-interconnections 75 in order to join the fixed contact pad 54 and the actuator pad 55 thereto.

A frame-shaped sealing pad structure 91 is formed in an outer peripheral portion in the lower surface of the cover substrate 71 in order to join the joining pad 53 thereto to seal a space between the cover substrate 71 and the device substrate 41.

Therefore, the cover substrate 71 is stacked on the device substrate 41, a solder layer 85 of the sealing pad structure 91 is stacked on the joining pad 53, and solder layers 85 of the connecting electrode structures 81 are aligned with the fixed contact pad 54 and the actuator pad 55. At this point, when the solder layers 85 are heated and melted, the sealing pad structure 91 is soldered to the joining pad 53 to seal the electrostatic relay 43 in the package. Because the solder is sufficiently deformed, high airtightness and reliability can be obtained using the solder as the sealing material. The connecting electrode structures 81 are connected to the fixed contact pad 54 and the actuator pad 55, and the fixed contact pad 54 and the actuator pad 55 are connected to the external connection terminals 76 through the through-interconnections 75. Therefore, in the electrostatic relay 43, a signal is taken out from the external connection terminal 76.

(Connecting Electrode Structure)

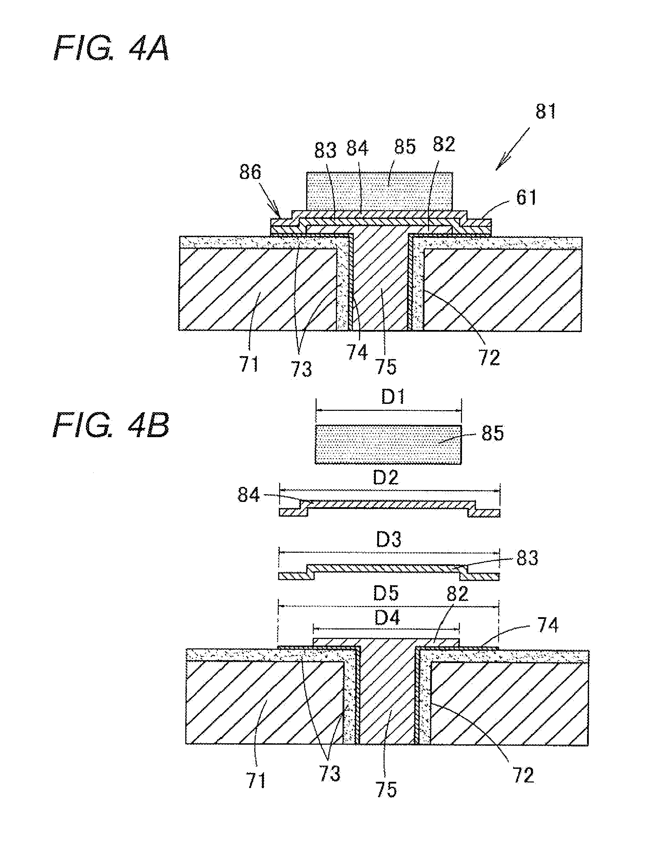

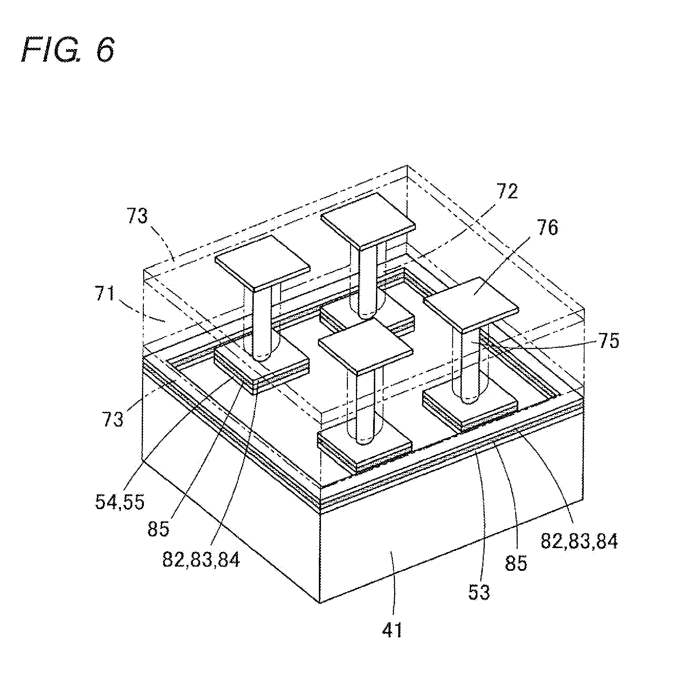

A structure of the connecting electrode structure 81 will be described below. Fig. 4A is an enlarged view showing an X portion of Fig. 3, that is, the connecting electrode structure 81 while the X portion is vertically inverted. Fig. 4B is an enlarged view showing the connecting electrode structure 81 while some layers of the X portion are separated from one another. Fig. 6 is a perspective view showing schematically a state in which the connecting electrode structure 81 and the sealing pad structure 91 are joined. The through-hole 72 is made in the cover substrate 71 made of Si. The inner surface of the through-hole 72 and the surface of the cover substrate 71 are covered with the insulating layer 73 made of $SiO_2$. In the surface of the insulating layer 73, the adhesion layer 74 is formed from the inner circumferential surface of the through-hole 72 to the periphery of the through-hole 72 in the surface of the cover substrate 71.

Cu is buried in the through-hole 72 to form the through-interconnection 75. In the surface of the cover substrate 71, a Cu electrode 82 whose diameter is larger than that of the through-hole 72 is provided in an end face of the through-interconnection 75 and the periphery of the end face. The through-interconnection 75 and the Cu electrode 82 are simultaneously formed by Cu electrolytic plating.

The adhesion layer 74 is provided between the insulating layer 73 and the through-interconnection 75, and the adhesion layer 74 has a function of making peel-off of the through-interconnection 75 from the insulating layer 73 difficult. Similarly the adhesion layer 74 provided between the insulating layer 73 and the Cu electrode 82 has a function of making the peel-off of the Cu electrode 82 from the insulating layer 73. Any material may be used as the adhesion layer 74 as long as the adhesion layer 74 enhances adhesiveness between cu and insulating layer 73 ($SiO_2$) to prevent the through-interconnection 75 from diffusing in the insulating layer 73 ($SiO_2$). For example, the adhesion layer 74 is deposited by sputtering Ti, TiN, TaN, and Ta.

As shown in Fig. 4, a diffusion preventing film 83, a wettability improving layer 84, and the solder layer 85 are sequentially formed on the Cu electrode 82.

The surface of the Cu electrode 82 is covered with the diffusion preventing film 83. The whole of the Cu electrode 82 is covered with the diffusion preventing film 83. The adhesion layer 74 is completely covered with the diffusion preventing film 83 such that the adhesion layer 74 is not exposed. A metallic compound is formed by the diffusion preventing film 83 and each of the lower-side material (Cu electrode 82) and the upper-side material (wettability improving layer 84) to obtain high joining strength. Meanwhile, the diffusion preventing film 83 prevents Cu of the Cu electrode 82 from diffusing onto the side of the solder layer 85, and the diffusion preventing film 83 prevents the solder of the solder layer 85 from diffusing onto the side of the Cu electrode 82. In the material for the diffusion preventing film 83, preferably a diffusion coefficient of Sn contained in the solder layer 85 is equal to or lower than $3 \times 10^{-23}$ cm²/sec. For example, Ni or Ti is used as the material for the diffusion preventing film 83.

As used herein, the diffusion means a phenomenon in which, when atoms B exist sparsely in a medium A, the atoms B spread from a high-concentration region of the atoms B to a low-concentration region to uniformize finally a distribution of the atoms B. In the diffusion process of the atom B, an amount of atom B (flow density) J passing through a unit sectional area is proportional to a concentration gradient (dc/dx) of the atom B, and the amount of atom B (flow density) J is expressed as follows:

$$J = -D(dc/dx)$$

where x is a distance in a direction perpendicular to the section

The proportionality coefficient D [cm²/sec] is called a diffusion coefficient.

The solder layer 85 is deformed by the heating to enable the sealing, and preferably lead-free Au-Sn solder is used as the solder layer 85.

The wettability improving layer 84 provided between the solder layer 85 and the diffusion preventing film 83 stabilizes wettability during melting of the Au-Sn solder layer 85 to prevent a joining defect caused by the solder layer 85, and the wettability improving layer 84 enhances the joining strength. Au or a metallic material containing Au is used as the wettability improving layer 84. Particularly Au is stable because Au is not oxidized. Therefore, the Cu electrode 82 can be protected from an outside environment when Au is used as the wettability improving layer 84.

A thickness of the Cu electrode 82 is decreased in order to decrease a thickness of the package, and desirably the Cu electrode 82 has the thickness of 2 μm or less. Desirably the diffusion preventing film 83 has the thickness of 1 μm or less. Desirably the solder layer 85 has the thickness of 3 μm or less after the joining. Accordingly, preferably the solder layer 85 provided on the wettability improving layer 84 has the thickness of 10 μm or less before the joining, more preferably the thickness of 5 μm or less. Although the wettability improving layer 84 preferably has the thickness of 3 μm or less, the wettability improving layer 84 may be removed according to an underlying material.

In the connecting electrode structure 81 shown in Fig. 4, Sn of the solder layer 85 can be prevented from diffusing onto the side of the Cu electrode 82 by the action of the diffusion preventing film 83. Accordingly, even if the Cu electrode 82 has the thickness of 2 μm or less, the crack, the void, and the peel-off are hardly generated at the interface between the diffusion preventing film 83 and the Cu electrode 82 or solder layer 85 to obtain the high joining strength.

The preferable dimensional relationship will be described below. Referring to Fig. 4B, in the surface of the cover substrate 71, an outside dimension D5 of the adhesion layer 74 is larger than an outside dimension D4 of the Cu electrode 82. An outside dimension D3 of the diffusion preventing film 83 is larger than the outside dimension D4 of the Cu electrode 82, and the diffusion preventing film 83 has a flange portion 61 that spreads out of the Cu electrode 82. The outside dimension D3 of the diffusion preventing film 83 is equal to or larger than the outside dimension D5 of the adhesion layer 74 in the surface of the cover substrate 71. An outside dimension D2 of the wettability improving layer 84 is equal to or larger than the outside dimension D3 of the diffusion preventing film 83, and the whole surface of the diffusion preventing film 83 is covered with the wettability improving layer 84. An outside dimension D1 of the solder layer 85 is equal to or smaller than the outside dimension D4 of the Cu electrode 82.

When the connecting electrode structure 81 has a rectangular shape or a polygonal shape as shown in Fig. 7B, the outside dimension of each layer expresses a length of one side of the connecting electrode structure 81. When the connecting electrode structure 81 has a circular shape or an ellipsoidal shape as shown in Fig. 7C, the outside dimension of each layer expresses a diameter of the connecting electrode structure 81. When the connecting electrode structure 81 has a band shape extending in a certain direction like the sealing pad structure 91, the outside dimension of each layer expresses a width of the connecting electrode structure 81. Hereinafter, it is assumed that the connecting electrode structure 81 has the circular shape, and occasionally the outside dimension is referred to as the diameter.

In the dimensional relationship, the thin flange portion 86 is formed in the periphery of the Cu electrode 82 while the adhesion layer 74, the diffusion preventing film 83, and the wettability improving layer 84 spread out of the Cu electrode 82. Because the Cu electrode 82 has the high thermal conductivity, the solder layer 85 located immediately above the Cu electrode 82 is easily deformed by the heat during the heating when the diameter of the solder layer 85 is set equal to or smaller than that of the Cu electrode 82. When the deformed solder layer 85 flows from above the Cu electrode 82 to the flange portion 61, the solder layer 85 is cooled by the flange portion 61 and easily solidified to hardly flow to the outside.

(Sealing Pad Structure)

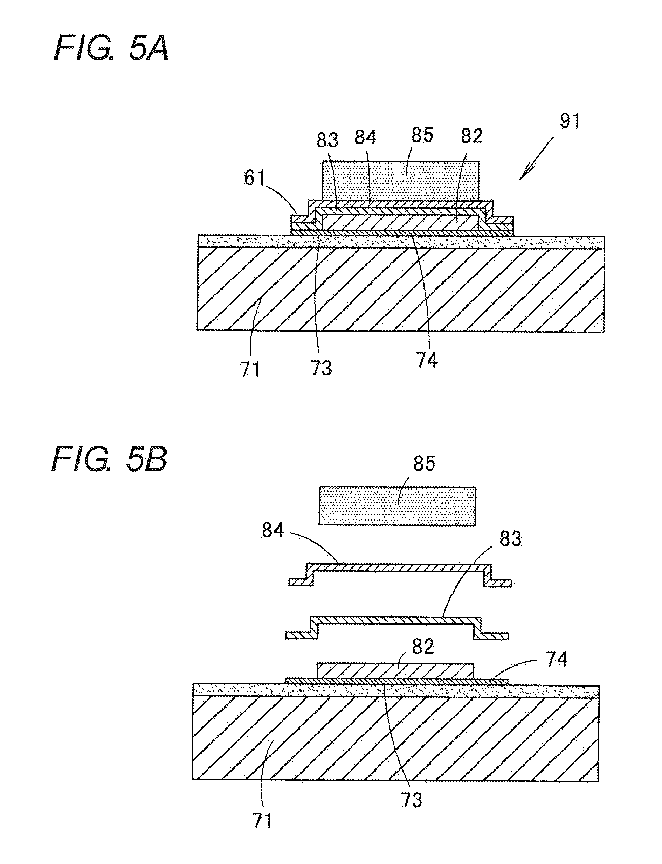

Fig. 5A is an enlarged view showing a Y portion of Fig. 3, that is, the sealing pad structure 91 while the Y portion is vertically inverted. Fig. 5B is an enlarged view showing the sealing pad structure 91 while some layers of the Y portion are separated from one another. In the sealing pad structure 91, the thin-film Cu electrode 82 is formed in the surface of the cover substrate 71, and the diffusion preventing film 83, the wettability improving layer 84, and the solder layer 85 are sequentially provided on the Cu electrode 82. In the sealing pad structure 91, there is no through-hole in the cover substrate 71. Accordingly, the configuration and effect described in the connecting electrode structure 81 are obtained except that the through-interconnection is not provided.

(Selection of Diffusion Preventing Film)

The reason the diffusion preventing film in which the diffusion coefficient of Sn is equal to or lower than $3 \times 10^{-23}$ cm$^2$/sec is used will be described below. The diffusion coefficients (unit: cm$^2$/sec, and temperature: 600°K) of Cu to various kinds of metals are as follows. An arrow indicates a diffusion direction by "diffused substance ← diffusing substance".
Ag ← Cu: $2 \times 10^{-16}$ to $2 \times 10^{-17}$

Al ← Cu: 0.9 to $1 \times 10^{-12}$
Ni ← Cu: 2 to $4 \times 10^{-23}$
Sn ← Cu: $3 \times 10^{-6}$
Ti ← Cu: $5 \times 10^{-14}$ to $4 \times 10m^{-18}$
TiN ← Cu: $6 \times 10^{-30}$
TaN ← Cu: $3 \times 10^{-18}$
Li ← Cu: $2 \times 10^{-16}$
Pb ← Cu: $2 \times 10^{-16}$
Based on the diffusion coefficient from Cu to Sn, when the material having the smaller diffusion coefficient is selected, Ag, Al, Ni, Ti, TiN, TaN, Li, and Pb are nominated.

On the other hand, the following two criteria can be considered as a criterion for selecting the diffusion preventing film.
(Criterion 1) a relationship between Cu that is of the through-interconnection material and the diffusion preventing film
(Criterion 2) a relationship between Sn that is of the solder material and the diffusion preventing film

At first the relationship (criterion 1) between Cu that is of the through-interconnection material and the diffusion preventing film will be discussed. For the criterion 1, a first condition is that the material (Cu) for the through-interconnection and the material for the diffusion preventing film are high-melting-point metals that are not melted in each other in an environment of a joining temperature of 260°C to 400°C. A second condition is that the film can generally be deposited by physical deposition or chemical deposition using the material suitable to a photolithographic process. From this viewpoint, Ag, Al, Ni, Ti, TiN, and TaN are suitable. This is because even Al whose melting point is the lowest has the melting point of 660°C.

Then the relationship (criterion 2) between Sn that is of the solder material and the diffusion preventing film will be discussed. For the criterion 2, it is considered whether a path in which Sn that is of the solder material diffuses to Cu can be prevented. Therefore, the diffusion coefficient in the direction of Sn → diffusion preventing film becomes a criterion for judgment. Each of the metals has the high diffusion coefficient in diffusion preventing film → Sn. This is attributed to the fact that, because Sn that is of the solder material is already melted around the joining temperature, the material for the diffusion preventing film diffuses deeply on the Sn side. However, this is not directly connected to the solution of the present invention. The diffusion preventing film should be selected by comprehensively making a determination from the diffusion coefficient of Cu and the criteria 1 and 2. It is necessary that the diffusion preventing film have the function of preventing the diffusion of Sn to the diffusion preventing film and the mutual diffusion of Cu and Sn. Therefore, the value of the diffusion coefficient in the direction of Sn → diffusion preventing film should be cited as the criterion for judgment.

The diffusion coefficients (unit: cm$^2$/sec, and temperature: 600°K) of Sn to various kinds of metals are as follows:

$Cu \leftarrow Sn: 4 \times 10^{-17}$
$Ti \leftarrow Sn: 2 \times 10^{-28}$
$Ni \leftarrow Sn: 3 \times 10^{-23}$
$Ag \leftarrow Sn: 1 \times 10^{-15}$
$Al \leftarrow Sn: 4 \times 10^{-11}$

The diffusion coefficient of Cu is also listed for reference. Fig. 8 is a sectional photograph showing the neighborhood of an interface between the Cu layer and the Sn layer when Sn diffuses in Cu. Accordingly, from the pieces of data, it can be determined that Ag and Al cannot be used because the diffusion of Sn is generated at a value of the diffusion coefficient of $Cu \leftarrow Sn$ or more. Fig. 9A is a sectional photograph showing a state in which Sn diffuses in Ti, and Fig. 9B is a sectional photograph showing a state in which Sn diffuses in Ni. As can be seen from Figs. 9A and 9B, the crack or the like is not generated for Ti or Ni.

Therefore, the generation of the defect such as the crack can be prevented in the electrode portion with Ti or Ni as the diffusion preventing film 83. From the diffusion value at this point, it is found that the material in which the diffusion coefficient of Sn is equal to or lower than $3 \times 10^{-23}$ cm$^2$/sec can be used as the diffusion preventing film 83.

(Production Process)

The cover substrate 71 is produced as follows. The switch unit, the electrostatic actuator, and the sealing portion 52 are prepared in the upper surface of the device substrate 41 by the MEMS production technology. The through-interconnection 75, the connecting electrode structure 81, and the sealing pad structure 91 are prepared in the cover substrate 71. Then the cover substrate 71 is overlapped on the Si substrate 41 in which the switch unit, the electrostatic actuator, and the sealing portion 52 are formed, the connecting electrode structure 81 is aligned with the fixed contact pad 54 and the actuator pad 55, and the sealing pad structure 91 is aligned with the joining pad 53. At this point, the heating and pressurization are performed under the conditions of the temperature of 260 to 400°C and the load pressure of 0.1 to 10 MPa, and the connecting electrode structure 81 is joined to the fixed contact pad 54 or the actuator pad 55 while the sealing pad structure 91 is joined to the joining pad 53 by deforming the solder layer 85. The environment (in chamber) may be set to a nitrogen atmosphere of around 30 Torr or a vacuum atmosphere higher than around 30 Torr during the joining treatment. As a result, the cover substrate 71 and the device substrate 41 are joined and integrated to seal the switch unit and the electrostatic actuator.

At this point, because the through-interconnection 75 is buried in the recess of the cover substrate 71 and is not exposed to the outer surface side of the cover substrate 71, the outer surface of the cover substrate 71 is ground or polished to expose the end face of the through-interconnection 75 to the outer surface of the cover substrate 71. Then the insulating layer 73 is formed in the outer surface of the cover substrate 71 by evaporation or sputtering, and the contact hole is made in the insulating layer 73 at the position corresponding to the end face of the through-interconnection 75. The external connection terminal 76 is provided on the contact hole, and the external connection terminal 76 is connected to the end face of the through-interconnection 75 through the contact hole.

The above-described processes are performed in a wafer size, and plural electrostatic relays 43 are produced once from the set of wafers. Accordingly, the set of wafers is separately cut by dicing or the like to produce the many electrostatic relays 43.

## Claims

1.  An electrode structure (81) being **characterized by** comprising:

    a Cu electrode (82) provided in a surface of a substrate (71);
    a diffusion preventing film (83) that is made of a material in which a diffusion coefficient of Sn is equal to or lower than $3 \times 10^{-23}$ cm$^2$/sec, the whole Cu electrode (82) being covered with the diffusion preventing film (83); and
    a solder layer (85) that is provided above the diffusion preventing film (83), the solder layer (85) being made of Au-Sn solder.

2.  The electrode structure (81) according to claim 1, **characterized in that** the diffusion preventing film (83) is made of Ni or Ti.

3.  The electrode structure (81) according to claim 1, **characterized in that** the Cu electrode (82) is a plug portion that is provided in an end portion of a through-interconnection (75) buried in a through-hole (72) of the substrate (71).

4.  The electrode structure (81) according to claim 1, **characterized in that** a wettability improving layer (84) is formed between the diffusion preventing film (83) and the solder layer (85) in order to improve wettability of the Au-Sn solder.

5.  The electrode structure (81) according to claim 1, **characterized in that** a thickness of the Cu electrode (82) is equal to or smaller than 2 $\mu$m.

6.  The electrode structure (81) according to claim 1, **characterized in that** the diffusion preventing film (83) includes a flange portion (61) that spreads out of the Cu electrode (82).

7.  The electrode structure (81) according to claim 1, **characterized in that** a thickness of the diffusion preventing film (83) is equal to or smaller than 1 μm.

8.  The electrode structure (81) according to claim 4, **characterized in that** a whole surface of the diffusion preventing film (83) is covered with the wettability improving layer (84).

9.  The electrode structure (81) according to claim 1, **characterized in that** a thickness of the solder layer (85) is equal to or lower than 5 μm.

10. The electrode structure (81) according to claim 1, **characterized in that** an area of the solder layer (85) is equal to or smaller than an area of the Cu electrode (82).

11. The electrode structure (81) according to claim 1, **characterized in that** the substrate (71) is a semiconductor substrate whose surface is covered with an insulating film (73), and
    an adhesion layer (74) is formed between the Cu electrode (82) and the insulating film (73) so as not to spread out of the diffusion preventing film (83), the adhesion layer (74) having an area larger than that of the Cu electrode (82).

12. The electrode structure (81) according to claim 11, **characterized in that** the adhesion layer (74) is one or a plurality of layers made of at least one kind of materials consisting of Ti, TiN, TaN, and Ta.

13. A microdevice package being **characterized by** comprising:

    a first substrate (41) on which a microdevice is mounted ; and
    a second substrate (71) that is joined to the first substrate (41) to seal the microdevice,
    wherein a connecting electrode portion (81) connected to the microdevice is formed by:

      an electrode structure according to claim 1, wherein the Cu electrode (82) is provided in an inner surface of the second substrate (71) in an end portion of a through-interconnection (75) buried in a through-hole (72) of the second substrate (71).

14. A microdevice package being **characterized by** comprising:

    a first substrate (41) on which a microdevice is mounted; and
    a second substrate (71) that is disposed opposite the first substrate (41),
    wherein a sealing pad portion (91) connected to the first substrate (41) is formed by:

      an electrode structure according to claim 1, wherein the Cu electrode (82) is provided along an outer peripheral portion in an inner surface of the second substrate (71).

15. The microdevice package according to claim 13 or 14, **characterized in that** a thickness of the solder layer (85) is equal to or lower than 3 μm after joining.

FIG. 1

FIG. 2

*FIG. 3*

*FIG. 4A*

*FIG. 4B*

## FIG. 5A

## FIG. 5B

FIG. 6

*FIG. 7A*

71  75  72

85  81

61

*FIG. 7B*  84  61  *FIG. 7C*

85  85  84

D1  D1

D2  D2

91

EP 2 366 658 A2

FIG. 8

CRACK

## FIG. 9A

Ti←Sn

## FIG. 9B

Ni←Sn

**REFERENCES CITED IN THE DESCRIPTION**

**Patent documents cited in the description**

- JP 6318625 A

- JP 2007149742 A